(19) Europäisches Patentamt
European Patent Office
Office européen des brevets

(11) **EP 3 299 113 B1**

(12) **EUROPEAN PATENT SPECIFICATION**

(45) Date of publication and mention
of the grant of the patent:
**12.12.2018 Bulletin 2018/50**

(51) Int Cl.:
**B23K 35/26** (2006.01)    **C22C 13/02** (2006.01)
**H05K 1/18** (2006.01)    **H05K 3/34** (2006.01)

(21) Application number: **16796071.5**

(22) Date of filing: **26.04.2016**

(86) International application number:
**PCT/JP2016/002195**

(87) International publication number:
**WO 2016/185674 (24.11.2016 Gazette 2016/47)**

(54) **SOLDER ALLOY AND PACKAGE STRUCTURE USING SAME**

LÖTLEGIERUNG UND VERPACKUNGSSTRUKTUR DAMIT

ALLIAGE DE SOUDAGE ET STRUCTURE D'EMBALLAGE L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.05.2015 JP 2015102180**
**05.02.2016 JP 2016021113**

(43) Date of publication of application:
**28.03.2018 Bulletin 2018/13**

(73) Proprietor: **Panasonic Intellectual Property Management Co., Ltd.**
**Osaka-shi, Osaka 540-6207 (JP)**

(72) Inventors:
• **HINE, Kiyohiro**
**Chuo-ku, Osaka-shi**
**Osaka 540-6207 (JP)**
• **FURUSAWA, Akio**
**Chuo-ku, Osaka-shi**
**Osaka 540-6207 (JP)**
• **KITAURA, Hidetoshi**
**Chuo-ku, Osaka-shi**
**Osaka 540-6207 (JP)**

(74) Representative: **Vigand, Philippe et al**
**Novagraaf International SA**
**Chemin de l'Echo 3**
**1213 Onex - Genève (CH)**

(56) References cited:
**WO-A1-02/40213**    **CN-A- 1 346 728**
**JP-A- 2004 188 453**    **JP-A- 2013 252 548**
**JP-A- 2015 020 182**    **JP-B1- 5 654 716**
**JP-B2- 5 280 520**    **US-A- 5 733 501**
**US-A1- 2014 054 766**

**Description**

TECHNICAL FIELD

The present invention relates to a solder alloy which is mainly used in soldering an electronic component to an electronic circuit board, and to a package structure using the solder alloy.

BACKGROUND ART

From a viewpoint of safety or comfortability of a vehicle, an influence on an environment, and the like, electronic control of the vehicle is in progress. An electronic device mounted in a vehicle is required to have high reliability for a load such as heat or vibration, and impact in the vehicle.

For such a request of an electronic device for a vehicle, a solder alloy used when the electronic device for a vehicle is mounted on a circuit board is required to have high reliability. The solder alloy has a melting point lower than that of a printed circuit board of a member to be bonded or an electronic component. Thus, mechanical characteristics in a high-temperature environment are significantly deteriorated. Because the solder alloy also has a small elastic modulus, loads occurring by distortion which occurs by a difference of a linear expansion coefficient between constituent members with changing a temperature in a vehicle environment, or occurring by vibration or impact are intensively applied to a solder bonding portion at which soldering is performed by a solder alloy. In particular, distortion occurring by a difference of a linear expansion coefficient between constituent members is repeatedly loaded, and thus cracks may occur at the solder bonding portion, and a probability that the solder bonding portion is finally broken may be considered. Thus, in a solder alloy used in an electronic device for a vehicle, thermal fatigue resistance against repeated distortion which occurs by changing a temperature is important, and high strength or ductility in a high-temperature environment is required.

As a conventional solder alloy which is usable for an electronic device for a vehicle and has excellent thermal fatigue resistance, a solder alloy formed from 1.0 to 4.0 mass% of Ag, 4.0 to 6.0 mass% of In, 0.1 to 1.0 mass% of Bi, 1 mass% or less (except for 0 mass%) which is the total content of one type or more elements selected from a group consisting of Cu, Ni, Co, Fe, and Sb, and Sn as the remainder is known. A bonding portion formed by using the solder alloy causes an electrode portion of an electronic component, which includes copper to be bonded to an electrode land of a board, which includes copper. An electronic component bonding body (package structure) in which a space between the electrode portion of the electronic component and the electrode land of the board is at least partially closed by a Cu-Sn intermetallic compound, in the bonding portion is known (PTL 1). PTL 1 discloses that the above configuration is provided, and thus it is possible to prevent an occurrence of fissure (crack) and extension in a temperature cycle test in a range of -40°C to 150°C.

As another solder alloy having excellent thermal fatigue resistance, a Sn solder alloy which is a Sn-Ag-In-Bi solder alloy in which 0.5 to 5 mass% of Ag, 0.5 to 20 mass% of In, and 0.1 to 3 mass% of Bi are contained, and the remainder is Sn, and which contains 3 mass% or less of at least one type selected from Sb, Zn, Ni, Ga, Ge, and Cu is also known (PTL 2). PTL 2 discloses that, according to the solder alloy, it is possible to prevent deformation of a solder alloy in a temperature (cool and hot) cycle test in a range of -40°C to 125°C.

Citation List

Patent Literature

PTL 1: Japanese Patent No. 5280520
PTL 2: Japanese Patent Unexamined Publication No. 2004-188453
PTL 3: Japanese Patent Unexamined Publication No. 2015-100833 (US2015144388A1)

JP 5654716 B1 discloses a solder alloy substantially consisting of tin, silver, indium, bismuth, and antimony, wherein with respect to the total amount of the solder alloy, the content ratio of the silver is 2.8 mass % or more and 4 mass % or less, the content ratio of the indium is 6.2 mass % or more and 9 mass % or less, the content ratio of the bismuth is 0.7 mass % or more and 5 mass % or less, the content ratio of the antimony is 0.3 mass % or more and 5 mass % or less, and the content ratio of the tin is the remaining ratio and the value of A in the following discriminant (1)

$$A = 0.87 \quad x \quad [\text{In content ratio (mass \%)}] \quad - \quad 0.41 \quad x \quad [\text{Ag content}$$

$$\text{ratio (mass \%)}] \quad - \quad 0.82 \quad x \quad [\text{Sb content ratio (mass \%)}] \quad\quad\quad (1)$$

is 4.36 or less.

SUMMARY OF THE INVENTION

An object of the present invention is to provide a solder alloy which can be proof against using at 175°C and obtain sufficient reliability.

The inventors independently found that, regarding a Sn-Ag-Bi-In solder alloy, both of Sb and Cu are necessarily added, the In content percentage is strictly controlled for the Sb content percentage, and thus high reliability is obtained at a high temperature which has not be considered in the related art, specifically, even at 175°C. As a result obtained by closer examination, the present invention was completed.

According to the present invention, there is provided a solder alloy in which 0.5 mass% or more and 1.25 mass% or less of Sb, In satisfying the following expression (I) or (II): in a case of 0.5≤[Sb]≤1.0, 5.5≤[In]≤5.50+1.06[Sb]...(I), in a case of 1.0<[Sb]≤1.25, 5.5≤[In]≤6.35+0.212[Sb] ...(II) (in the expression, [Sb] indicates a Sb content percentage (mass%) and [In] indicates an In content percentage (mass%)), 0.5 mass% or more and 1.2 mass% or less of Cu, 0.1 mass% or more and 3.0 mass% or less of Bi, and 1.0 mass% or more and 4.0 mass% or less of Ag are contained, and the remainder is formed from Sn, wherein an alloy structure which contains at least a γ phase and a β-Sn phase, in which Sb is subjected to solid solution, is provided at 150°C or higher.

According to the present invention, it is realized a solder alloy which can be proof against using at 175°C and obtain sufficient reliability by selecting a predetermined content percentage for each element except for Sn in a solder alloy formed from Sn, Ag, Bi, In, Cu, and Sb, particularly, by setting the Sb content percentage to be 0.5 mass% or more and 1.25 mass% or less and selecting the In content percentage in a relationship with the Sb content percentage so as to satisfy the expression (I) or (II), and setting the Cu content percentage to be 0.5 mass% or more and 1.2 mass% or less.

BRIEF DESCRIPTION OF DRAWINGS

FIG. 1 is a graph illustrating a DSC measurement result of a solder alloy according to an exemplary embodiment of the present invention.
FIG. 2 is a graph illustrating a result of a tensile test of the solder alloy according to the exemplary embodiment of the present invention, in an environment of 175°C.
FIG. 3 is a graph illustrating a relationship (in a case where a Sb content percentage is 0.5 mass%) between an In content percentage and a transformation temperature of the solder alloy according to the exemplary embodiment of the present invention.

DESCRIPTION OF EMBODIMENTS

Ahead of descriptions for an exemplary embodiment of the present invention, a problem of the conventional solder alloy will be simply described. The number of electronic devices mounted in a vehicle is gradually increased, and thus it is difficult to ensure a mounting space for the electronic devices in a limited space of the vehicle. Thus, a technique in which a space is relatively expanded by reducing the size of an electronic device, or a technique in which an electronic device is mounted at a place like an engine room, at which the temperature becomes higher and thus mounting has not been performed conventionally from a viewpoint of reliability, proceeds. As a result, heating density of an electronic device may be increased by reducing the size thereof, or a temperature in the surrounding environment may be increased. Thus, the electronic device is exposed by a higher temperature. Thus, in order to respond to forward evolution of the electronic device, a solder alloy which exhibits high reliability, for example, high thermal fatigue resistance at a temperature higher than 125°C or 150°C which is used as the conventional basis, specifically, even at a temperature of 175°C is required.

However, using the solder alloy at such a high temperature is not considered in the related art. In more detail, the solder alloy disclosed in PTL 1 is assumed to be used up to only 150°C, and the solder alloy disclosed in PTL 2 is assumed to be used up to only 125°C. In the conventional solder alloy, necessarily obtaining sufficient reliability is not possible at a temperature of 175°C.

Hereinafter, a solder alloy according to one exemplary embodiment of the present invention, and a package structure using the solder alloy will be described in detail with reference to the drawings.

In the specification, in a case of Attaching [] to a symbol of an element constituting a solder alloy, [] is assumed to mean a content percentage (mass%) of the element in the solder alloy.

In this specification, when a metal composition of the solder alloy will be described, a numerical value or a numerical range may be shown just ahead of a metal element other than Sn. This means that mass% (=weight%) of each element occupied in a metal composition is indicated by a numerical value or a numerical range, and the remainder is formed from Sn, as is generally used in this technical field.

The solder alloy according to this exemplary embodiment contains 0.5 mass% or more and 1.25 mass% or less of Sb, In satisfying the following expression (I) or (II): in a case of $0.5 \leq [Sb] \leq 1.0$, $5.5 \leq [In] \leq 5.50+1.06[Sb]$...(I), and in a case of $1.0 < [Sb] \leq 1.25$, $5.5 \leq [In] \leq 6.35+0.212[Sb]$...(II) (in the expression, [Sb] indicates a Sb content percentage (mass%) and [In] indicates an In content percentage (mass%)), 0.5 mass% or more and 1.2 mass% or less of Cu, 0.1 mass% or more and 3.0 mass% or less of Bi, 1.0 mass% or more and 4.0 mass% or less of Ag, and the remainder is formed from Sn.

In the related art, an effect for physical properties influencing thermal fatigue resistance, such as strength or ductility of a solder alloy itself has not been clearly described. A complex effect in a case of containing a combination of Cu and Sb also has not been verified. Under this circumstance, the inventors newly found that research and development for mechanical characteristics in a high-temperature environment, which are required for an electronic device for a vehicle was performed, and as a result, each of In, Cu, and Sb was contained in a range having a certain specific relation, and thus the mechanical characteristics at a high temperature (which has not been clarified until now), particularly, ductility at a high temperature was significantly improved, and thermal-resistant fatigue strength was improved.

In order to clarify the effect of the solder alloy in this exemplary embodiment, a solder alloy (sample) having a predetermined composition was manufactured and evaluation was performed.

The sample to be evaluated in this exemplary embodiment was manufactured by the following method.

Regarding Sn, Ag, Bi, In, Cu, and Sb contained in a solder alloy, 3.5 mass% of Ag, 0.5 mass% of Bi, 6.0 mass% of In, 0.8 mass% of Cu, 0.5 mass% of Sb, and Sn as the remainder were weighted so as to cause the total to be 100 g.

The weighted Sn was put into a ceramics crucible. Adjustment to be temperature of 500°C and a nitrogen atmosphere was performed, and the ceramics crucible was installed in an electric type jacket heater.

After it was confirmed that Sn was melted, In was put and stirring was performed for three minutes.

Bi was put, and stirring was performed for three minutes.

Ag was put, and stirring was performed for three minutes.

Sb was put, and stirring was performed for three minutes.

Cu was put, and stirring was performed for three minutes.

Then, the crucible was picked up from the electric type jacket heater. The crucible was immersed in a vessel which was full with water of 25°C, so as to be cooled. Thus, a solder alloy was manufactured.

The manufactured solder alloy is referred to as "a solder alloy A" below, and an alloy composition thereof is represented by Sn-3.5Ag-0.5Bi-6.0In-0.8Cu-0.5Sb.

For comparison, as an example of a solder alloy in the related art, a solder alloy which did not contain Sb, and had a composition of Sn-3.5Ag-0.5Bi-6.0In-0.5Cu was manufactured in a manner similar to the above descriptions. The solder alloy manufactured in this manner is referred to as "Conventional Example 1".

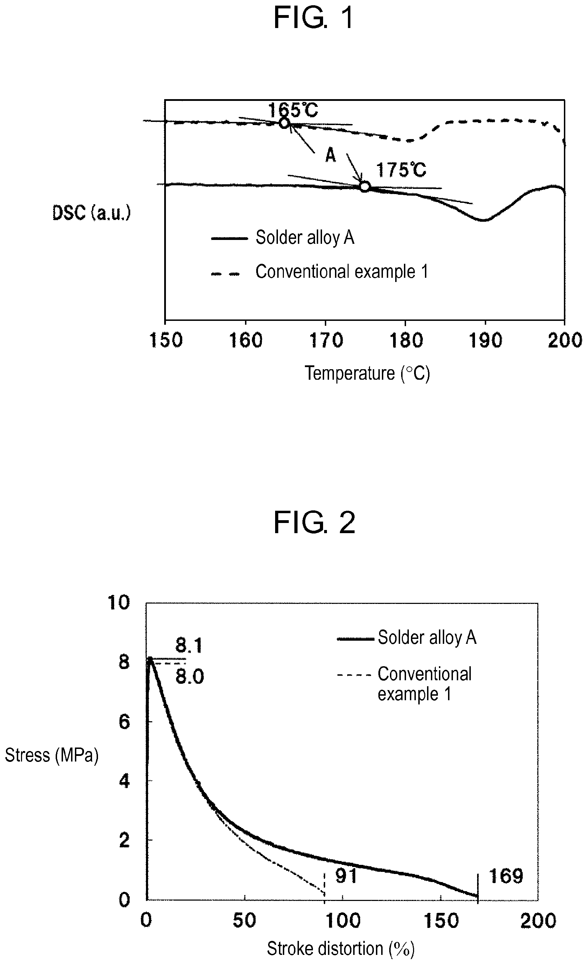

In order to evaluate a transformation temperature, 10 mg of the solder alloy manufactured in the above manner was picked up, and differential scanning calorimetry (DSC) was performed. The transformation temperature is a temperature at which phase transformation between β-Sn and γ rapidly proceeds. A temperature rising rate in measuring was set to 10°C/minute, and measurement was performed in a range of 25°C to 250°C. FIG. 1 illustrates a result.

In FIG. 1, the transformation temperature was obtained by an inflection point of small peaks (A part) which are provided in a space from a low temperature (solid) side to a peak indicating a melting point. The transformation temperature of the solder alloy A was 175°C. The transformation temperature of Conventional Example 1 was 165°C.

Then, 1 g of the solder alloy manufactured in the above manner was picked up. Soldering was performed on a Cu plate at 250°C by using a commercial flux, and a temperature cycle test was performed. As a test condition, a temperature between -40°C and 175°C was set, and holding was performed at each of -40°C and 175°C for 30 minutes, for one cycle (a test having the condition is referred to as "the -40/175°C temperature cycle test"). This process was performed for 500 cycles.

As a result, in the solder alloy A, self-transformation at a stage after 500 cycles was not observed. However, in Conventional Example 1, self-transformation occurred. According to the above result, it is understood that, in a solder alloy having a transformation temperature of 175°C or higher, self-transformation does not occur in the -40/175°C temperature cycle test, and the solder alloy is proof against using in an environment of 175°C.

Then, in order to evaluate mechanical characteristics of the solder alloy, a tensile test in an environment of 175°C was performed by using a tensile test piece. The tensile test piece was manufactured in a manner that the solder alloy manufactured in the above manner was put into a crucible, heating was performed at 250°C in an electric type jacket heater, so as to be melted, and the molten solder alloy was caused to flow into a cast which was machined to have a shape of the tensile test piece and was formed of graphite. The tensile test piece had a round bar shape which had a narrowed portion. The narrowed portion was 3 mm in diameter, and 15 mm in length. FIG. 2 illustrates a result of the tensile test in the environment of 175°C.

In FIG. 2, a horizontal axis indicates stroke distortion of a tensile test machine, and a vertical axis indicates tensile stress. The maximum value thereof is elongated after fracture, and is measured as tensile strength. From FIG. 2, it is understood that the solder alloy A has tensile strength which is equivalent to or is equal to or more than that in Conventional Example 1, even in the environment of 175°C. Regarding the breaking elongation of the solder alloy A, large improvement of tens% in comparison to Conventional Example 1 is shown. Thus, it is understood that ductility at a high temperature is improved.

From the above descriptions, it is confirmed that the solder alloy A is not self-transformed even though repetitive exposure to a high temperature of 175°C is performed, and the solder alloy A has excellent mechanical characteristics of a solder alloy, which refers to strength or ductility at a high temperature. Thus, it is possible to improve thermal fatigue resistance of a solder bonding portion.

Next, regarding the solder alloy in the exemplary embodiment, an alloy composition for exhibiting the effect will be described.

(In Content Percentage and Sb Content Percentage)

Firstly, the In content percentage and the Sb content percentage in the solder alloy will be described.

In a solder alloy in which Sn is used as the main component, An alloy ($\beta$-Sn phase) in which In is subjected to solid solution in Sn is formed in a low In-content-percentage range in which the In content percentage is equal to or less than about 15 mass%.

Solid solution is a phenomenon that a portion of crystal lattice of parent metal is replaced with a solid solution element at an atom level. As a general effect of the solid solution element, a difference of an atom diameter a parent metal element and the solid solution element causes distortion to occur in crystal lattice of the parent element, and thus it is possible to suppress movement of crystal defects such as transition, when stress is applied. As a result, it is possible to improve strength of metal, and to degrade ductility when stress is applied. Strength of a solder alloy by solid solution is improved more as the content percentage of the solid solution element is increased.

However, in a case where In is subjected to solid solution in Sn solder, phase transformation occurs in accordance with the In content percentage. However, in a case where the temperature is gradually increased, when the temperature is increased to be equal to or higher than about 100°C, phase transformation from the $\beta$-Sn phase to a $\gamma$ phase ($InSn_4$) having a different structure proceeds. That is, a state ($\gamma$+$\beta$-Sn) where two different phases of the same degree coexist occurs. The two-phase coexistence state occurs, and thus contribution of slipping at a particle boundary becomes large, and ductility at a high temperature is improved.

In a case where the In content percentage is large, transformation from the $\beta$-Sn phase to the $\gamma$ phase excessively occurs. In this case, because the volume of a crystal lattice structure of the $\gamma$ phase is different from the volume of a crystal lattice structure of the $\beta$-Sn phase, a repetitive heat cycle is performed, and thus self-transformation of the solder alloy occurs. This causes breaking in the inside of the solder bonding portion or causes a short circuit between different solder bonding portions. Thus, this is a problem.

Sb raises the transformation temperature in a Sn-In alloy, for example, as with the transformation temperature 165°C in Conventional Example 1 and the transformation temperature 175°C of the solder alloy A which are described above.

This is because a state of an alloy structure is changed by Sb containing. In a case where the Sb content percentage is relatively small, Sb is subjected to solid solution in Sn in a Sn-In alloy, similarly to In. Further, if the Sb content percentage is large, Sb forms a compound (InSb) along with In, and is precipitated in an alloy structure.

Sb along with In is subjected to solid solution in Sn, and thus element movement of Sn or In when the temperature is changed is suppressed, and a transformation starting temperature of the $\beta$-Sn phase and the $\gamma$ phase is changed.

Sb is subjected to solid solution, and thus the mechanical characteristics of a solder alloy causes strength of the solder alloy to be improved similar to that in In solid solution. In addition, although will be described later, the inventors newly find that solid solution of Sb accelerates improvement of ductility at a high temperature, which is observed in a case of a specific In content percentage.

Further, if the Sb content percentage is large, InSb is precipitated between crystal structures, like a pin, and thus transformation is suppressed. Meanwhile, because precipitation of InSb degrades ductility, excessive precipitation of InSb is inappropriate for improving thermal fatigue resistance.

In order to clarify an influence of a Sn-In solder alloy on the transformation temperature by the Sb content percentage, a solder alloy having a metal composition shown in Table 1 was manufactured and evaluated. A manufacturing method of the solder alloy is similar to the above descriptions.

[Table 1]

| | Metal composition (mass%) | | | | | | Transformation temperature (°C) | | 175°C | | | | Determination |
|---|---|---|---|---|---|---|---|---|---|---|---|---|---|
| | Sn | Ag | Bi | In | Cu | Sb | | | Tensile strength (MPa) | | Extension (%) | | |
| Example 1-1 | bal. | 3.5 | 0.5 | 6.0 | 0.8 | 0.50 | 175 | B | 8.1 | B | 169 | A | A |
| Example 1-2 | bal. | 3.5 | 0.5 | 6.0 | 0.8 | 0.75 | 180 | B | 8.1 | B | 164 | A | A |
| Example 1-3 | bal. | 3.5 | 0.5 | 6.0 | 0.8 | 1.00 | 185 | B | 8.2 | B | 125 | A | A |
| Example 1-4 | bal. | 3.5 | 0.5 | 6.0 | 0.8 | 1.25 | 186 | B | 8.5 | B | 98 | B | B |
| Comparative Example 1-1 | bal. | 3.5 | 0.5 | 6.0 | 0.8 | - | 165 | C | 8.0 | B | 95 | B | C |
| Comparative Example 1-2 | bal. | 3.5 | 0.5 | 6.0 | 0.8 | 0.25 | 168 | C | 8.0 | C | 142 | B | C |
| Comparative Example 1-3 | bal. | 3.5 | 0.5 | 6.0 | 0.8 | 1.50 | 187 | B | 9.0 | B | 85 | C | C |
| Conventional Example 1 | bal. | 3.5 | 0.5 | 6.0 | 0.5 | - | 165 | - | 8.0 | - | 91 | - | - |

(in Table 1, "bal." indicates the remainder. This is set to be similar in the following tables.)

In Table 1, regarding the transformation temperature of the manufactured solder alloy, a case of being equal to or higher than 175°C was evaluated to be "B", and a case of being lower than 175°C was evaluated to be "C". Regarding the mechanical characteristics (tensile strength and extension) at 175°C, a case of being improved in comparison to a case of Conventional Example 1 was evaluated to be "B", and a case of being equivalent or less was evaluated to be "C". In particle, a case where extension at 175°C was improved by 30% or more was evaluated to be "A".

Further, in Table 1, the transformation temperature of the manufactured solder alloy, and the mechanical characteristics (tensile strength and extension) thereof at 175°C were evaluated, and results which were collectively determined were shown together. A case where the transformation temperature is equal to or higher than 175°C, and the mechanical characteristics are improved in comparison to a case of Conventional Example 1 is determined to be "B". In particle, a case where extension at 175°C is improved by 30% or more is determined to be "A". Thus, it is determined that the effect of the present invention was exhibited. A case where the transformation temperature is lower than 175°C or the value of the mechanical characteristics is less than the value in a case of Conventional Example 1 is determined to be "C".

As in Examples 1-1 to 1-4, in a case where 0.50 to 1.25 mass% of Sb is contained, the transformation temperature is equal to or higher than 175°C, the mechanical characteristics are improved, and the effect of the present invention is exhibited. In a case where the Sb content percentage described in Comparative Examples 1-1 and 1-2 is equal to or less than 0.25 mass%, the mechanical characteristics at 175°C is good. However, an increase of the transformation temperature is insufficient, and the transformation temperature is lower than 175°C, and thus determination is "C". In a case where the Sb content percentage described in Comparative Example 1-3 is 1.5 mass%, InSb is significantly generated. Thus, ductility at a high temperature is deteriorated, and the determination is "C".

With the results shown in Table 1, it is understood that the effect of the present invention is exhibited in a case where the Sb content percentage is in a range of 0.5 mass% to 1.25 mass%.

From Examples 1-1 to 1-4 and Comparative Example 1-1, it is understood that the Sb content percentage in a case of not containing Sb, and an increase of the transformation temperature has a relationship as represented by the following expression (1).

$$\text{(Expression 1)}$$

$$\text{In a case of } 0.5 \leq [\text{Sb}] \leq 1.0:$$

$$\Delta T_t = 20 \times [\text{Sb}]$$

$$\text{In a case of } 1.0 < [\text{Sb}] \leq 1.25:$$

$$\Delta T_t = 4 \times [\text{Sb}] + 16$$

(in the expression, $\Delta T_t$ indicates an increase quantity (°C) of the transformation temperature).

Then, in order to clarify an influence of the In content percentage, a solder alloy having a metal composition shown in Table 2 was manufactured and evaluated. The Sb content percentage is set to 0.50 mass% which is the smallest in the above descriptions, and the manufacturing method and the evaluation method of a solder alloy are similar to those in the above descriptions.

[Table 2]

| | Metal composition (mass%) | | | | | | Transformation temperature (°C) | | 175°C | | | | Determination |
|---|---|---|---|---|---|---|---|---|---|---|---|---|---|
| | Sn | Ag | Bi | In | Cu | Sb | | | Tensile strength (MPa) | | Extension (%) | | |
| Example 2-1 | bal. | 3.5 | 0.5 | 5.5 | 0.8 | 0.50 | 185 | B | 8.0 | B | 155 | A | A |
| Example 2-2 | bal. | 3.5 | 0.5 | 6.0 | 0.8 | 0.50 | 175 | B | 8.1 | B | 169 | A | A |
| Comparative Example 2-1 | bal. | 3.5 | 0.5 | 5.0 | 0.8 | 0.50 | 194 | B | 7.9 | C | 95 | B | C |
| Comparative Example 2-2 | bal. | 3.5 | 0.5 | 6.5 | 0.8 | 0.50 | 166 | C | 8.2 | B | 139 | A | C |
| Comparative Example 2-3 | bal. | 3.5 | 0.5 | 7.0 | 0.8 | 0.50 | 156 | C | 8.0 | B | 105 | B | C |
| Comparative Example 2-4 | bal. | 3.5 | 0.5 | 7.5 | 0.8 | 0.50 | 147 | C | 8.1 | B | 70 | C | C |
| Conventional Example 1 | bal. | 3.5 | 0.5 | 6.0 | 0.5 | - | 165 | - | 8.0 | - | 91 | - | - |

As shown in Table 2, it is understood that, if Example 2-2 and Conventional Example 1 are compared to each other, the transformation temperature is increased by the Sb content. Example 2-2 is a case where the Sb content percentage is 0.5 mass%. In a case where the Sb content percentage is 0.5 mass%, in Examples 2-1 and 2-2 in which the In content percentage is 5.5 mass% and 6.0 mass%, respectively, any of the transformation temperature and the mechanical characteristics (tensile strength and extension) at 175°C is improved. The transformation temperature is lowered with an increase of the In content percentage. In Comparative Examples 2-2 and 2-3 in which the In content percentage is 6.5 mass% and 7.5 mass% respectively, The mechanical characteristics at a high temperature are good. However, the transformation temperature is lower than 175°C, and thus the determination is "C". Further, in Comparative Example 2-4 in which the In content percentage is large, that is, 7.5 mass%, the transformation temperature and the mechanical characteristics at 175°C together are insufficient. Thus, the determination is "C". From a result of evaluation of the mechanical characteristics (tensile strength and extension), in Comparative Example 2-1 in which the In content percentage is 5.0 mass%, the tensile strength at 175°C is smaller than that in Conventional Example 1 in which the effect by solid solution of In is small, and thus the determination is "C".

Then, as shown in Table 3, in a case where the Sb content percentage is set to be an upper limit, that is, 1.25 mass%, a solder alloy was manufactured and evaluated. The manufacturing method and the evaluation method of a solder alloy are similar to those in the above descriptions.

[Table 3]

| | Metal composition (mass%) | | | | | | Transformation temperature (°C) | | 175°C | | | | Determination |
|---|---|---|---|---|---|---|---|---|---|---|---|---|---|
| | Sn | Ag | Bi | In | Cu | Sb | | | Tensile strength (MPa) | | Extension (%) | | |
| Example 3-1 | bal. | 3.5 | 0.5 | 5.5 | 0.8 | 1.25 | 195 | B | 8.2 | B | 93 | B | B |
| Example 3-2 | bal. | 3.5 | 0.5 | 6.0 | 0.8 | 1.25 | 186 | B | 8.5 | B | 98 | B | B |
| Example 3-3 | bal. | 3.5 | 0.5 | 6.5 | 0.8 | 1.25 | 176 | B | 8.6 | B | 102 | B | B |
| Comparative Example 3-1 | bal. | 3.5 | 0.5 | 5.0 | 0.8 | 1.25 | 204 | B | 7.9 | C | 92 | B | C |
| Comparative Example 3-2 | bal. | 3.5 | 0.5 | 7.0 | 0.8 | 1.25 | 166 | C | 8.0 | B | 60 | C | C |
| Comparative Example 3-3 | bal. | 3.5 | 0.5 | 7.5 | 0.8 | 1.25 | 157 | C | 8.0 | B | 52 | C | C |
| Conventional Example 1 | bal. | 3.5 | 0.5 | 6.0 | 0.5 | - | 165 | - | 8.0 | - | 91 | - | C |

As shown in Table 3, it is understood that, if Example 3-2 and Conventional Example 1 are compared to each other, the transformation temperature is increased by the Sb content. Similarly to a case of the result shown in Table 2, the transformation temperature is lowered with an increase of the In content percentage. In Comparative Examples 3-2 and 3-3 in which the In content percentage is equal to or higher than 7.0 mass%, The transformation temperature is lower than 175°C, and thus the determination is "C". Focusing on the mechanical characteristics of the tensile strength and extension, in a case of Comparative Example 3-1 in which the In content percentage is 5.0 mass%, the solid-solution effect of In is not sufficiently exhibited, and the tensile strength in the environment of 175°C is smaller than that in Conventional Example 1. Thus, the determination is "C".

The range of the In content percentage for exhibiting the effect of the present invention is as follows, based on the results shown in Tables 2 and 3.

In a case where the Sb content percentage is $0.5 \leq [Sb] \leq 1.25$, focusing on a relationship between the In content percentage and the mechanical characteristics is attracted, it is necessary that the In content percentage is equal to or more than 5.5 mass%, for exhibiting the effect of the present invention, and the relationship of (Expression 2) is provided.

(Expression 2)

$$[In] \geq 5.5$$

Then, a relationship between the In content percentage and the transformation temperature is attracted.

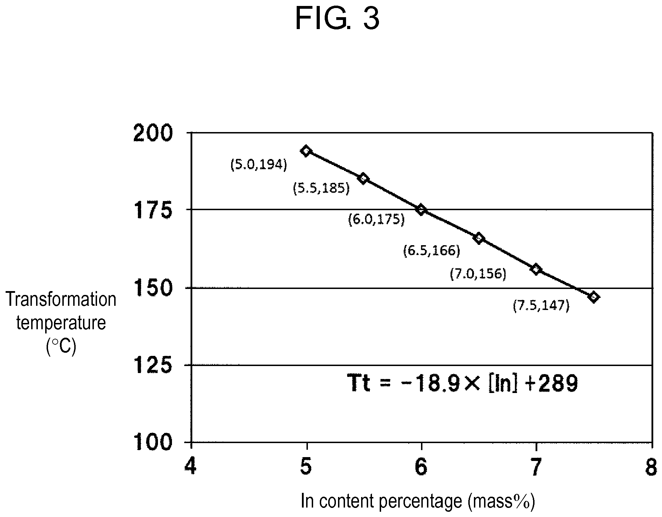

FIG. 3 is a diagram illustrating a relationship between the In content percentage and the transformation temperature in a case where the Sb content percentage shown in Table 2 is 0.50 mass%. In FIG. 3, The horizontal axis indicates the In content percentage (mass%), and the vertical axis indicates the transformation temperature (°C).

In a case where the Sb content percentage is 0.50 mass%, the relationship between the In content percentage and the transformation temperature is a relationship of the following Expression 3.

(Expression 3)

$$T_t = -18.9 \times [In] + 289$$

(In the expression, Tt indicates the transformation temperature (°C)).

With Table 1, the transformation temperature rising effect by the Sb content is 10°C. Thus, in a case of not containing Sb, a relationship as shown in the following Expression 4 is provided.

(Expression 4)

$$T_t = -18.9 \times [In] + 279$$

(In the expression, Tt indicates the transformation temperature (°C)).

From the results, a relationship as shown in Expression 5 is required for exhibiting the effect of the present invention, in which the transformation temperature is equal to or higher than 175°C, and the mechanical characteristics of a solder alloy are improved.

(Expression 5)

$$5.5 \leq [In] \leq 6.5$$

and
In a case of $0.5 \leq [Sb] \leq 1.0$:

$$-18.9 \times [In] + 279 + 20 \times [Sb] \geq 175$$

In a case of $1.0 < [Sb] \leq 1.25$:

$$-18.9\times[\text{In}]+279+4\times[\text{Sb}]+16\geq175.$$

With Expressions 1, 2, and 5, the In content percentage (mass%) and the Sb content percentage (mass%) for exhibiting the effect of the present invention are required to satisfy a relationship of the following Expression 6.

$$(\text{Expression 6})$$

$$0.5\leq[\text{Sb}]\leq1.25$$

$$\text{and}$$

$$\text{in a case of } 0.5\leq[\text{Sb}]\leq1.0:$$

$$5.5\leq[\text{In}]\leq5.50+1.06\times[\text{Sb}]$$

$$\text{in a case of } 1.0<[\text{Sb}]\leq1.25:$$

$$5.5\leq[\text{In}]\leq6.35+0.212\times[\text{Sb}].$$

In order to clarify a composition range for particularly exhibiting improvement of ductility at a high temperature, which is one of the effects of the present invention, as shown in Table 4, A solder alloy in a case where the Sb content percentage is 0.75 mass% and 1.0 mass% and the In content percentage satisfies a relationship of Expression 6 was manufactured and a relationship with the In content percentage was evaluated in detail. The manufacturing method and the evaluation method of a solder alloy are similar to those in the above descriptions.

[Table 4]

| | Metal composition (mass%) | | | | | | Transformation temperature (°C) | | 175°C | | | | Determination |
|---|---|---|---|---|---|---|---|---|---|---|---|---|---|
| | Sn | Ag | Bi | In | Cu | Sb | | | Tensile strength (MPa) | | Extension (%) | | |
| Example 4-1 | bal. | 3.5 | 0.5 | 6.0 | 0.8 | 0.75 | 180 | B | 8.1 | B | 164 | A | A |
| Example 4-2 | bal. | 3.5 | 0.5 | 6.1 | 0.8 | 0.75 | 179 | B | 8.1 | B | 142 | A | A |
| Example 4-3 | bal. | 3.5 | 0.5 | 6.2 | 0.8 | 0.75 | 177 | B | 8.2 | B | 118 | B | B |
| Example 4-4 | bal. | 3.5 | 0.5 | 6.0 | 0.8 | 1.00 | 185 | B | 8.2 | B | 125 | A | A |
| Example 4-5 | bal. | 3.5 | 0.5 | 6.1 | 0.8 | 1.00 | 184 | B | 8.2 | B | 132 | A | A |
| Example 4-6 | bal. | 3.5 | 0.5 | 6.2 | 0.8 | 1.00 | 182 | B | 8.2 | B | 114 | B | B |
| Example 4-7 | bal. | 3.5 | 0.5 | 6.3 | 0.8 | 1.00 | 180 | B | 8.3 | B | 110 | B | B |
| Example 4-8 | bal. | 3.5 | 0.5 | 6.4 | 0.8 | 1.00 | 178 | B | 8.3 | B | 107 | B | B |
| Example 4-9 | bal. | 3.5 | 0.5 | 6.5 | 0.8 | 1.00 | 176 | B | 8.4 | B | 105 | B | B |
| Conventional Example 1 | bal. | 3.5 | 0.5 | 6.0 | 0.5 | - | 165 | - | 8.0 | - | 91 | - | - |

As shown in Table 4, even in a case of any of Examples 4-1 to 4-9, the transformation temperature and the mechanical characteristics are increased in comparison to Conventional Example 1. Focusing on the extension at 175°C, it is understood that the extension indicates a higher value as the In content percentage becomes smaller, in a range of the In content percentage which is equal to or more than 6.0 mass%. In the range, in a case where the In content percentage is equal to or less than 6.1 mass%, the extension at 175°C is particularly large. Thus, the determination is "A".

With the result shown in Table 4, in order to exhibit the effect of the present invention, it is particularly desirable that the In content percentage (mass%) and the Sb content percentage (mass%) satisfy a relationship of the following Expression 7.

$$(\text{Expression 7})$$

$$0.5 \leq [\text{Sb}] \leq 1.0$$

$$\text{and}$$

$$5.5 \leq [\text{In}] \leq 5.50 + 1.06 \times [\text{Sb}]$$

$$\text{and}$$

$$[\text{In}] \leq 6.1$$

(Cu content percentage)

Cu is contained in order to lower a melting point in soldering and to improve selectivity of a material of a member to be bonded.

As the member to be bonded in soldering, a medium obtained by performing various types of plating or pre-flux treatment on Cu or Ni as a base material is mainly provided.

Among the substances, in a case where the base material of the member to be bonded is Ni, when soldering is performed by a solder alloy which contains In, and does not contain Cu or contains the small amount of Cu, some amount of In are taken in an interface reaction layer ($Ni_3Sn_4$). Thus, the mechanical characteristics at a solder bonding portion after soldering are changed. Thus, in a case where the base material of the member to be bonded is Ni, it is necessary that many of In are contained in advance, by the amount of In taken into the interface reaction layer. However, in a practical circuit board, various electronic components are mounted on one circuit board. Thus, in a case where electronic components in which the base material is Cu and Ni respectively are mounted, it is difficult that the In content percentage is adjusted in advance.

However, the predetermined amount of Cu is contained in the solder alloy, and thus Cu in the solder alloy during soldering forms a $Cu_6Sn_5$ alloy layer in the interface reaction layer. Thus, it is possible to prevent intake of In, and selectivity of a member to be bonded is improved.

It is clearly described in Japanese Patent Unexamined Publication No. 2015-100833 by the this applicant, that the Cu content percentage is equal to or more than 0.5 mass% in order to exhibit such an effect of Cu containing. Thus, the lower limit value of the Cu content percentage is 0.5 mass%.

If Cu is excessively contained, the melting point is increased. Thus, being equal to or less than 1.2 mass% is desirable.

Thus, in the solder alloy according to the present invention, the Cu content percentage is set to be 0.5 mass% or more and 1.2 mass% or less.

(Bi content percentage)

Bi is contained for the purpose of improving mechanical strength of a solder material, and of lowering the melting point. In a solder alloy, in a case where the Bi content percentage is relatively small, that is, equal to or less than 3.0 mass%, solid solution is formed to have the $\beta$-Sn phase. If the Bi content percentage is large, Bi is provided in a form in which a Bi compound is precipitated.

In order to obtain the effect of improving the mechanical strength by Bi containing, 0.1 mass% or more of Bi is necessarily contained, and 0.1 mass% or more of the Bi content percentage is desirably contained.

In a case where precipitation of Bi or a Bi compound occurs, action of preventing slipping at an interface is shown. Thus, the ductility at a high temperature is significantly degraded. Thus, it is desirable that an upper limit of the Bi content percentage is set to be equal to or less than 3.0 mass% in which precipitation of Bi or a Bi compound does not occur.

With the above descriptions, in the solder alloy of the present invention, the Bi content percentage is set to be 0.1 mass% or more and 3.0 mass% or less.

(Ag content percentage)

Ag is contained for the purpose of improving wettability in soldering, and of lowering the melting point. In a solder alloy, Ag is provided in a form of a $Ag_3Sn$ compound and $Ag_2In$.

Generally, in order to uniquely melt a solder alloy by reflow soldering, a reflow peak temperature which is equal to or higher than +10°C of a liquidus temperature of the solder alloy is preferably set. In addition, if a thermal-resistant temperature of an electronic component is considered, the reflow peak temperature is preferably set to be equal to or lower than 240°C.

Thus, the liquidus temperature of the solder alloy is preferably set to be equal to or lower than 230°C. In the solder alloy of the present invention, The Ag content percentage is set to be 1.0 mass% or more and 4.0 mass% or less.

Solder alloys in an example, a comparative example, and a conventional example, which have a metal composition shown in Table 5 based on the content percentage of each element determined in the above-described manner were manufactured and the thermal fatigue resistance was evaluated. A manufacturing method of the solder alloy is similar to the above descriptions.

An evaluation method of the thermal fatigue resistance is as follows.

Firstly, the manufactured solder alloy is machined to be solder powder having a particle diameter of tens $\mu$m, and the solder powder and a flux were weight to have a weight ratio of 90:10. The solder powder and the flux were kneaded, and thus a solder paste was manufactured. This solder paste was printed on a circuit board electrode on a circuit board by using a metal mask having a thickness of 150 $\mu$m. A chip resistor was mounted on the printed solder paste, and reflow heating was performed under a condition of the maximum 240°C. Thus, a package structure was manufactured. A base material of the used circuit board electrode of the circuit board was Cu and Ni.

The -40°C/175°C temperature cycle test was performed on the package structure manufactured in such a manner, and transformation of a solder bonding portion after 2,000 cycles was visually observed. Electrical connection in a case where transformation was not recognized in visual observation was evaluated. A case where a change of a resistance value from that in the initial time was equal to or more than 10% was determined to be electrical poorness "provided". A case where the change did not occur or the change was equal to or less than 10% was determined to be electrical poorness "none". "-" in the field of the electrical poorness in Table 5 indicates that evaluation was not performed.

[Table 5]

| | Metal composition (mass%) | | | | | | Self-transformation | Electrical poorness | |
| | | | | | | | | circuit board electrode base material | |
| | Sn | Ag | Bi | In | Cu | Sb | | Cu | Ni |
|---|---|---|---|---|---|---|---|---|---|
| Example 5-1 | bal. | 3.5 | 0.5 | 5.5 | 0.8 | 0.50 | none | none | none |
| Example 5-2 | bal. | 3.5 | 0.5 | 5.5 | 0.8 | 1.25 | none | none | none |
| Example 5-3 | bal. | 3.5 | 0.5 | 6.0 | 0.8 | 0.50 | none | none | none |
| Example 5-4 | bal. | 3.5 | 0.5 | 6.0 | 0.8 | 1.25 | none | none | none |
| Example 5-5 | bal. | 3.5 | 0.5 | 6.5 | 0.8 | 1.25 | none | none | none |
| Example 5-6 | bal. | 3.5 | 0.5 | 6.0 | 0.5 | 0.50 | none | none | none |
| Example 5-7 | bal. | 3.5 | 0.5 | 6.0 | 1.2 | 0.50 | none | none | none |
| Example 5-8 | bal. | 3.5 | 0.1 | 6.0 | 0.8 | 0.50 | none | none | none |
| Example 5-9 | bal. | 3.5 | 3.0 | 6.0 | 0.8 | 0.50 | none | none | none |
| Example 5-10 | bal. | 1.0 | 0.5 | 6.0 | 0.8 | 0.50 | none | none | none |
| Example 5-11 | bal. | 4.0 | 0.5 | 6.0 | 0.8 | 0.50 | none | none | none |
| Comparative Example 5-1 | bal. | 3.5 | 0.5 | 6.0 | 0.8 | - | transformation | - | - |

(continued)

| | Metal composition (mass%) | | | | | | Self-transformation | Electrical poorness | |
| --- | --- | --- | --- | --- | --- | --- | --- | --- | --- |
| | | | | | | | | circuit board electrode base material | |
| | Sn | Ag | Bi | In | Cu | Sb | | Cu | Ni |
| Comparative Example 5-2 | bal. | 3.5 | 0.5 | 6.0 | 0.8 | 1.50 | none | occurrence | occurrence |
| Comparative Example 5-3 | bal. | 3.5 | 0.5 | 5.0 | 0.8 | 0.50 | none | occurrence | occurrence |
| Comparative Example 5-4 | bal. | 3.5 | 0.5 | 7.0 | 0.8 | 0.50 | transformation | - | - |
| Comparative Example 5-5 | bal. | 3.5 | 0.5 | 6.0 | - | 0.50 | none | none | occurrence |
| Comparative Example 5-6 | bal. | 3.5 | 0.5 | 6.0 | 1.5 | 0.50 | none | occurrence | occurrence |
| Comparative Example 5-7 | bal. | 3.5 | - | 6.0 | 0.8 | 0.50 | none | occurrence | occurrence |
| Comparative Example 5-8 | bal. | 3.5 | 3.5 | 6.0 | 0.8 | 0.50 | none | occurrence | occurrence |
| Comparative Example 5-9 | bal. | - | 0.5 | 6.0 | 0.8 | 0.50 | none | occurrence | occurrence |
| Conventional Example 1 | bal. | 3.5 | 0.5 | 6.0 | 0.5 | - | transformation | - | - |
| Conventional Example 2 | bal. | 3.5 | 0.5 | 8.0 | 0.5 | - | transformation | - | - |
| Conventional Example 3 | bal. | 3.5 | 0.5 | 8.0 | - | 0.5 | transformation | - | - |
| Conventional Example 4 | bal. | 3.5 | 0.5 | 8.0 | - | 1.5 | transformation | - | - |
| Conventional Example 5 | bal. | 3.5 | 0.5 | 8.0 | - | 3.0 | transformation | - | - |

As shown in Table 5, in Examples 5-1 to 5-11 included in the composition range of a solder alloy, which was determined in the above-described manner, self-transformation at a solder bonding portion did not occur and electrical poorness of a short circuit or disconnection did not occur.

In Comparative Examples 5-1 to 5-4 having different In and Sb content percentages, any of the self-transformation at a solder bonding portion and the electrical poorness occurred.

In Comparative Example 5-5 in which Cu was not contained, the self-transformation at a solder bonding portion did not occur. In a case where the base material of a circuit board electrode is Ni, disconnection occurred.

In Comparative Example 5-6 in which the Cu content percentage was 1.5 mass%, Comparative Example 5-7 in which Bi was not contained, Comparative Example 5-8 in which the Bi content percentage was 3.5 mass%, and Comparative Example 5-9 in which Ag was not contained, the electrical poorness occurred.

In any of Conventional Examples 1 to 5, the self-transformation at a solder bonding portion occurred.

Thus, from evaluation results shown in Tables 1 to 5, in a solder alloy in which 0.5 mass% or more and 1.25 mass% or less of Sb, In satisfying the following expression (I) or (II): in a case of $0.5 \leq [Sb] \leq 1.0$, $5.5 \leq [In] \leq 5.50 + 1.06[Sb]$...(I), and in a case of $1.0 < [Sb] \leq 1.25$, $5.5 \leq [In] \leq 6.35 + 0.212[Sb]$ ...(II) (in the expression, [Sb] indicates a Sb content percentage (mass%) and [In] indicates an In content percentage (mass%)), 0.5 mass% or more and 1.2 mass% or less of Cu, 0.1 mass% or more and 3.0 mass% or less of Bi, 1.0 mass% or more and 4.0 mass% or less of Ag were contained, and the remainder was formed from Sn, showing the effect of the present invention was confirmed. The solder alloy is configured by an alloy structure which contains at least the $\gamma$ phase and the $\beta$-Sn phase in which Sb was subjected to solid solution at 150°C or higher. Even in the environment of 175°C, a bonding portion having excellent thermal fatigue resistance can be formed.

More desirably, the solder alloy contains 0.5 mass% or more and 1.0 mass% or less of Sb, In which satisfies the following expression (I): 5.5≤[In]≤5.50+1.06[Sb] ...(I), 0.5 mass% or more and 1.2 mass% or less of Cu, 0.1 mass% or more and 3.0 mass% or less of Bi, 1.0 mass% or more and 4.0 mass% or less of Ag, and the remainder is formed from Sn. The solder alloy is configured by an alloy structure which contains at least the γ phase and the β-Sn phase in which Sb was subjected to solid solution at 150°C or higher. Even in the environment of 175°C, a bonding portion having more excellent thermal fatigue resistance can be formed.

More desirably, the solder alloy contains 0.5 mass% or more and 1.0 mass% or less of Sb, In which satisfies the following expression (I): 5.5≤[In]≤5.50+1.06[Sb]...(I), and which is equal to or less than 6.1 mass%, 0.5 mass% or more and 1.2 mass% or less of Cu, 0.1 mass% or more and 3.0 mass% or less of Bi, 1.0 mass% or more and 4.0 mass% or less of Ag, and the remainder is formed from Sn. The solder alloy is configured by an alloy structure which contains at least the γ phase and the β-Sn phase in which Sb was subjected to solid solution at 150°C or higher. Even in the environment of 175°C, a bonding portion having particularly excellent thermal fatigue resistance can be formed.

In The package structure according to the present invention, an electrode portion of an electronic component and an electrode portion of a circuit board are bonded to each other by the above-described solder alloy. According to this, even in the environment of 175°C, it is possible to provide a package structure having bonding which is more excellent in thermal fatigue resistance.

As the electronic component and the circuit board, any may be used. The electrode portion of an electronic component and the electrode portion of a circuit board may be formed from an appropriate conductive material. The portions may contain Cu and/or Ni as described above as a member to be bonded. The solder alloy may have any form. The solder alloy may be used singly (for example, in a form of powder, thread solder, a molten liquid, and preform solder) in soldering, or may be used integrally with a flux (for example, in a form of a solder paste, or cored solder) in soldering. Conditions of soldering may be appropriately selected.

In one aspect of the present invention, in the solder alloy, the Sb content percentage may be 0.5 mass% to 1.0 mass%, and the In content percentage may satisfy the above Expression (I).

In the aspect of the present invention, it may be further satisfied that the In content percentage is equal to or less than 6.1 mass%.

The solder alloy in the present invention has an alloy structure which contains at least the γ phase and the β-Sn phase in which Sb is subjected to solid solution at 150°C or higher.

According to another one main point of the present invention, there is provided a package structure in which an electronic component is mounted on a circuit board. In the package structure, an electrode portion of the electronic component and an electrode portion of the circuit board are bonded to each other by the solder alloy in the present invention.

In the present invention, "the solder alloy" may contain the fine amount of metal to be unavoidably mixed, as long as the metal composition is substantially configured by the exemplified metal. The solder alloy may have a certain form. For example, the solder alloy may be used singly or integrally with other component (for example, flux and the like) other than metal, in soldering.

INDUSTRIAL APPLICABILITY

The solder alloy and the package structure according to the present invention can realize a solder bonding portion having excellent mechanical characteristics even in a high-temperature environment of 175°C. For example, the solder alloy is used in a package structure and the like for electric components for a vehicle, which needs ensuring of electric conduction for a long term in a high-temperature environment, such as an engine room. Thus, the solder alloy and the package structure are useful.

**Claims**

1. A solder alloy containing;
   0.5 mass% or more and 1.25 mass% or less of Sb, In satisfying the following expression (I) or (II):

   in a case of 0.5≤[Sb]≤1.0,

$$5.5 \leq [\text{In}] \leq 5.50 + 1.06[\text{Sb}] \ldots (\text{I})$$

in a case of 1.0<[Sb]≤1.25,

$$5.5 \leq [In] \leq 6.35 + 0.212[Sb]\ldots(II)$$

wherein in the expression, [Sb] indicates a Sb content percentage in mass% and [In] indicates an In content percentage in mass%, 0.5 mass% or more and 1.2 mass% or less of Cu,
0.1 mass% or more and 3.0 mass% or less of Bi,
1.0 mass% or more and 4.0 mass% or less of Ag, and
has a remainder formed from Sn,
wherein an alloy structure which contains at least a $\gamma$ phase and a $\beta$-Sn phase, in which Sb is subjected to solid solution, is provided at 150°C or higher.

2. The solder alloy according to claim 1, wherein
the Sb content percentage is 0.5 mass% or more and 1.0 mass% or less, and
the In content percentage satisfies the expression (I).

3. The solder alloy according to claim 2, wherein
the In content percentage further satisfies being 6.1 mass% or less.

4. A package structure in which an electronic component is mounted in a circuit board, wherein
an electrode portion of the electronic component and an electrode portion of the circuit board are bonded to each other by the solder alloy according to any one of claims 1 to 3.

**Patentansprüche**

1. Lötlegierung umfassend:

0,5 Massen-% oder mehr und 1,25 Massen-% oder weniger von Sb, In, wobei der folgende Ausdruck (I) oder (II) erfüllt ist:

in einem Fall von 0,5 ≤ [Sb] ≤ 1,0,

$$5,5 \leq [In] \leq 5,50 + 1,06[Sb]\ \ldots(I)$$

in einem Fall von 1,0 < [Sb] ≤ 1,25,

$$5,5 \leq [In] \leq 6,35 + 0,212[Sb]\ \ldots(II)$$

wobei in dem Ausdruck [Sb] einen Prozentsatz des Sb-Gehalts in Massen-% anzeigt und

[In] einen Prozentsatz des In-Gehalts in Massen-% anzeigt
0,5 Massen-% oder mehr und 1,2 Massen-% oder weniger Cu;
0,1 Massen-% oder mehr und 3,0 Massen-% oder weniger Bi;
1,0 Massen-% oder mehr und 4,0 Massen-% oder weniger Ag; und
einen Rest aufweist, der aus Sn gebildet ist,
wobei eine Legierungsstruktur, die mindestens eine $\gamma$-Phase und eine $\beta$-Sn-Phase enthält, in der Sb einer festen Lösung ausgesetzt ist, bei 150 °C oder höher bereitgestellt wird.

2. Lötlegierung nach Anspruch 1, wobei
der Prozentsatz des Sb-Gehalts 0,5 Massen-% oder mehr und 1,0 Massen-% oder weniger beträgt, und
der Prozentsatz des In-Gehalts der Formel (I) entspricht.

3. Lötlegierung nach Anspruch 2, wobei

der Prozentsatz des In-Gehalts sie ferner mit 6,1 Massen-% oder weniger erfüllt.

**4.** Verpackungsstruktur in der eine elektronische Komponente in eine Leiterplatte montiert ist, wobei ein Elektrodenabschnitt der elektronischen Komponente und ein Elektrodenabschnitt der Leiterplatte durch die Lötlegierung nach einem der Ansprüche 1 bis 3 zusammengefügt sind.

**Revendications**

**1.** Alliage de soudage contenant :

0,5 % en masse ou plus et 1,25 % en masse ou moins de Sb, In satisfaisant à l'expression (I) ou (II) suivante :

dans le cas où $0,5 \leq [Sb] \leq 1,0$,

$$5,5 \leq [In] \leq 5,50 + 1,06[Sb] \ ...(I)$$

dans le cas où $1,0 < [Sb] \leq 1,25$,

$$5,5 \leq [In] \leq 6,35 + 0,212[Sb] \ ...(II)$$

dans lequel, dans l'expression, [Sb] indique la teneur en Sb en pourcentage en masse, et [In] indique la teneur en In en pourcentage en masse,

0,5 % en masse ou plus et 1,2 % en masse ou moins de Cu,
0,1 % en masse ou plus et 3,0 % en masse ou moins de Bi,
1,0 % en masse ou plus et 4,0 % en masse ou moins d'Ag, et
le reste étant formé de Sn,
dans lequel la structure d'alliage qui contient au moins une phase $\gamma$ et une phase $\beta$-Sn dans laquelle Sb est soumis à une solution solide, est obtenue à 150 °C ou plus.

**2.** Alliage de soudage selon la revendication 1, dans lequel
la teneur en Sb en pourcentage est de 0,5 % en masse ou plus et de 1,0 % en masse ou moins, et
la teneur en In en pourcentage satisfait à l'expression (I) .

**3.** Alliage de soudage selon la revendication 2, dans lequel
la teneur en In en pourcentage satisfait en outre au fait d'être de 6,1 % en masse ou moins.

**4.** Structure de boîtier dans laquelle un composant électronique est monté dans une carte de circuit imprimé, dans laquelle
une partie d'électrode du composant électronique et une partie d'électrode de la carte de circuit imprimé sont collées l'une à l'autre par l'alliage de soudage selon l'une quelconque des revendications 1 à 3.

# FIG. 1

# FIG. 2

# FIG. 3

$$Tt = -18.9 \times [In] + 289$$

(5.0,194)
(5.5,185)
(6.0,175)
(6.5,166)
(7.0,156)
(7.5,147)

Transformation temperature (°C)

In content percentage (mass%)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5280520 B
- JP 2004188453 A
- JP 2015100833 A
- US 2015144388 A1
- JP 5654716 B